# EUROPEAN PATENT SPECIFICATION

(11) **EP 3 035 071 B1**
(45) Date of publication and mention of the grant of the patent: **18.11.2020**
(21) Application number: 15197004.3
(22) Date of filing: 30.11.2015
(51) Int. Cl.: G01S 3/46, H04B 10/00, B64B 1/50, H04B 10/2575, H01S 5/042

(54) **SIGNAL TRANSMISSION AND HOLDING DEVICE FOR AIR-BORNE ANTENNAS OF AN RF-LOCATING SYSTEM**
SIGNAL-ÜBERTRAGUNGS- UND HALTEVORRICHTUNG FÜR BORDANTENNEN IN EINEM RF-ORTUNGSSYSTEM
TRANSMISSION DE SIGNAL ET DISPOSITIF DE RETENUE POUR DES ANTENNES EMBARQUÉES D'UN SYSTÈME DE LOCALISATION RF

(30) Priority: 30.11.2014 DE 102014017665
(43) Date of publication of application: 22.06.2016
(73) Proprietor: Saab Sensor Systems Germany GmbH, 90411 Nürnberg (DE)
(72) Inventor: Kolb, Dirk, 91080 Uttenreuth (DE); Salow, Erhard, 91080 Uttenreuth (DE)
(74) Representative: Benedum, Ulrich Max

(56) References cited:
- WO-A1-02/061971
- FR-A1- 2 886 491
- US-A1- 2002 167 702
- US-B2- 6 711 190

## Description

### TECHNICAL FIELD

The invention relates to the transmission of radio frequency signals between airborne antennas and the processing devices of an RF-locating system. More specifically, the invention relates to a device for transmission of signals from an antenna, e.g. of an RF-locating system, to a close-by or detached signal processing device.

### TECHNICAL BACKGROUND

The demand for locating the emitters of radio frequency (RF) has dramatically increased in the fields of public safety, spectrum regulation, security, intelligence and emergencies. Civil and military authorities have to determine regularly the locations of emitters of radio frequency, for example when criminals and terrorists are communicating with each other using cellular phones or radiotelephones and/or when electromagnetic interferences compromise the safety or function of other electromagnetic devices and services, or in cases of emergency, counter-intelligence or hostilities.

Conventional methods of locating the position of emitters of radio frequency comprise the so-called method of AOA (Angle-Of-Arrival), TOA (Time-Of-Arrival) and TDOA (Time-Difference-Of-Arrival), each method having benefits and drawbacks. The required line-of-sight between the emitter and the antenna(s) further represents a problem in urban environments because of tall buildings or hills and valleys and because of other stationary and mobile electromagnetic obstacles. A line-of-sight connection between the emitter and the antenna(s) of the locating apparatus must therefore be established which is not easy often as the location of the emitter is not known.

A conventional approach to overcome the problem of the missing line-of-sight connection is increasing the height of the antennas or choosing a high position for the antenna such as on the top of a hill or a tall building or a tower. However, a fixed stationary antenna position restricts the locating performance, and using tall mobile antenna masts or post is cumbersome and costly. In practice, the mast of a mobile antenna is limited to a height of up to some ten meters and such an antenna mast is a bulky and heavy device. It takes time and effort to raise the mast, and a van is needed to carry the mast and the necessary equipment. This means that the potential possible working positions of such masts are restricted to places where a van can go to, and the height of the antennas that can be achieved with such a mast is often not sufficient to establish a line-of-sight.

WO 02/061971 and US 2002/167702 relate to air-borne antenna for conventional mobile telecoms and wireless. FR 2 886 491 and US 6 711 190 disclose devices for devices for transmitting signals and represent technical back-ground.

The prior art therefore represents a problems since there are no cost-efficient methods which can be used by mobile units (automobiles or vans) to establish a line-of-sight connection between their locating systems and unknown emitters of radio frequency signals within complex or urban environments. Thus, the RF-locating-methods therefore require improvement.

### SUMMARY OF THE INVENTION

This object is achieved by a method of locating an RF-emitter on the ground comprising the steps recited in claim 1. Preferred embodiments of this method are disclosed in dependent claims 2 to 4. A further aspect of the invention is disclosed in claim 5 which relates a system operable to locate an RF-emitter on the ground. Preferred embodiments of the system have been disclosed in dependent claims 6 to 8.

The present invention provides a system which allows a high positioning of the antenna of an RF-locating system above ground and a transmitting of the received antenna signals to the processing equipment of the locating system on the ground while still working with a low-cost and easy-to-handle equipment.

Consequently, the present disclosure relates to an aerial antenna platform comprising a tethered balloon, one or more air-borne broad-band antennas and a platform-based signal amplifier and converter for transmitting optical signals to a ground-based signal processing equipment, wherein a tether holds the aerial platform in place and a fibre optical link transmits signals from said aerial platform to a signal processing equipment on the ground, wherein said aerial platform comprises a power supply to reduce the payload of the aerial platform by not having a power line to a ground-based power supply for the platform-based signal amplifier and converter. The circuity of the signal converter comprises a laser diode biased by a DC-current.

Thus, the aerial antenna platform may comprise a wide band amplifier that amplifies the antenna signals to a suitable level; an electric-optic-converter circuit that converts the amplified antenna signals to optical signals for transmission on the fibre optical link and a (self-contained) power supply which supplies power to the wide band amplifier and the electric-optic-converter circuit, and wherein power supply, amplifier, and converter may form an air-borne electronic device which converts received signals by the air-borne antenna, eg RF signals from a ground based RF-emitter, to optical signals for transmission via the fibre optic link to a ground-based signal processing unit, preferably for locating the source of the RF-signals.

The aerial antenna platform with the electric-optic-converter circuit may in one embodiment comprise a laser diode, which is biased by a DC-current to adjust the operating point of the laser diode. In a preferred embodiment, the DC-current which biases the laser diode is passed through the wide band amplifier and is regulated by a controlled current source which adjusts and stabilizes the operating point of the laser diode such that a separate resistor for biasing the laser diode is not needed and to reduce power consumption from the power supply and consequently the weight of the power supply.

In most preferred embodiment, tether and fibre optical link are essentially integrated in a fibre optic cable, which has a protective covering reinforced by synthetic fibres to improve the tensile strength of the fibre optic cable. The fibre optic cable may then be used as a stay rope. It is contemplated to use further global positioning systems for obtaining precise times and positions of the air-borne antennas as well as of the ground-based processing unit and in order to improve the overall preciseness of the RF-locating system.

The aerial platform may consist of one or more balloons and one or more kites or kite-like elements. The kites may be used to stabilize the position of the balloon on windy days. The one or more balloons may alternative have wings or winged parts for a stable position. Such type of balloons are known as helikite®. Of course, a hydrogen or helium filled flying aerostat such as a blub or zeppelin may also be suitable as an aerial platform.

Another embodiment of the present disclosure relates to the use of said aerial platform to establish a line of sight-sight connection with an RF-emitter on the ground for an RF-locating system. Thus, the method of locating an RF-emitter may comprise the step of using a fibre optic cable having high tensile strength to raise an aerial platform comprising a balloon or an aerodynamically shaped aerostat with one or more broad-antennas, a power supply for a wide band amplifier 210 and an electric-optic converter, a wide band amplifier that amplifies the antenna signals and an electric-optic-converter that converts the amplified electrical antenna signals to optical signals for transmission on a fibre optical link to a ground based signal processing unit. The ground-based signal-processing unit may further comprise a mast antenna for a stationary locating of the RF-emitter on the ground. The RF-emitter locating may be done in a one-step procedure using the received RF-signals by the air-borne antennas and the received RF-signals by the mast antenna and the length of the stay-rope - in combination with topography - to calculate finally the location of the RF-emitter on the ground. The advantage of this set-up lies therein that the entire procedure can be done stationary and thus quick and in one-step while the RF-emitter is emitting.

Further preferred embodiments of the invention are disclosed in the claims, the drawings and in the examples, which have described for illustration only and a better understanding of the invention. The desired scope of protection however shall not be limited in any way to the illustrative embodiments and examples but are defined in the set of claims below.

### BRIEF DESCRIPTION OF THE DRAWINGS

In the accompanying set of drawings:
- **Fig. 1**: shows a diagram of an RF-locating system with airborne antennas;
- **Fig. 2**: shows the electronic devices of the airborne part of the RF-locating system in Fig. 1 in more detail;
- **Fig. 3**: shows a basic circuit diagram of prior art electric-optic-converters;
- **Fig. 4**: shows a circuit diagram of the electric-optic-converter of the invention in Fig. 2; and
- **Fig 5**: an example of an RF-locating system with one airborne antenna and one ground-based antenna, which allows without any further the locating of a ground-based RF-emitter.

### DETAILED DESCRIPTION OF THE EMBODIMENTS

An embodiment of the invention will now be described in detail with reference to the accompanying drawings.

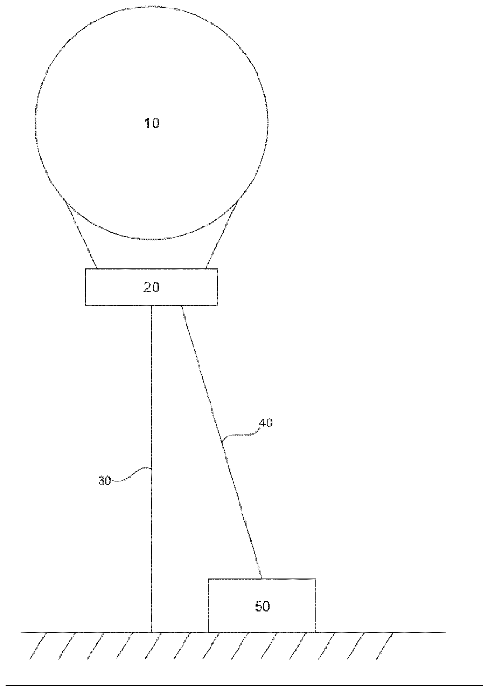

Fig. 1 shows a diagram of an RF-locating system with airborne antennas. The principles of the invention may be explained using a drawing of only one balloon; therefore, only one balloon 10 is depicted. Of course, according to the specific design of the RF-locating system, the system may comprise several identical balloons (for example three or four balloons) that carry antennas. Each captive or tethered balloon 10 carries an airborne part 20 of the RF-locating system (the airborne part 20 comprises an antenna or antennas 200 and electronic devices). Each captive balloon 10 is inflated with a suitable gas (for example helium or hydrogen) and raised to a position that likely allows a line-of-sight connection between the antennas and the unknown emitters of RF-signals that are to be located. Each balloon 10 is kept in position with a stay rope 30 that is fixed to the ground. The received signals of each antenna 200 are transmitted to a processing equipment 50 on the ground by a signal transmission line 40. The signals of all balloons of one locating system are commonly processed for locating purposes.

In this description, the term "captive balloon" comprises balloons with a rotationally symmetrical form, for example spherical or bulb-shaped balloons. The term "captive balloon" further comprises balloons that do not have a rotationally symmetrical form, for example balloons having an asymmetrical body and having means (for example blades, fins, wings) that form a kite and urge the balloon in a definite and stable orientation against the wind. Balloons of this type are commercially available (for example "Helikite®"). The reason for contemplating this kind of asymmetrical stably oriented balloons is that symmetrical balloons may rotate around the stay rope 30 under unfavourable wind conditions, twist the signal transmission line 40, and thus damage the signal transmission line. A spherically shaped balloon has advantages over an aerostat, an aerodynamically shaped balloon, in that a spherical balloon has a higher volume to surface ratio and thus can have a higher payload.

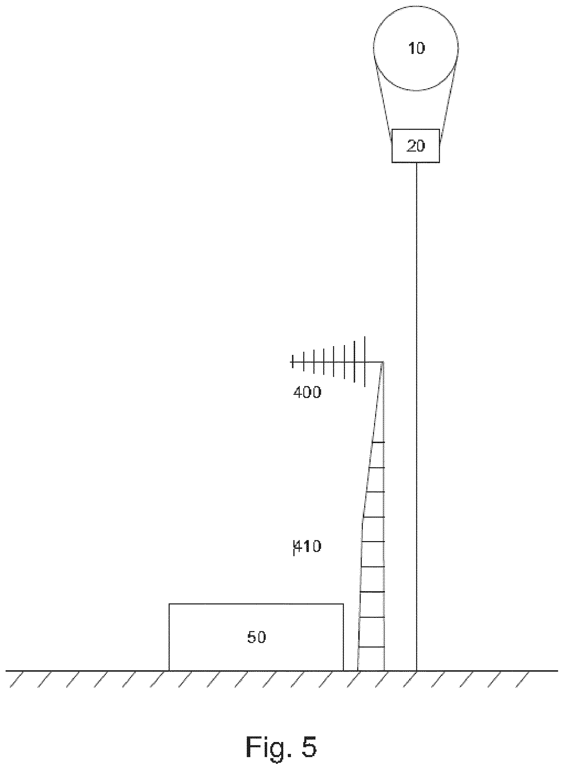

As stated above, the RF-locating system may comprise one or more tethered balloons 10. An example for an RF-locating system with only one airborne antenna (one captive balloon 10) is shown in Fig. 5. Fig. 5 shows an RF-locating system with the processing equipment 50 on the ground, a directional antenna 400 on a mast 410 and one captive balloon 10 with the airborne apparatus 20 comprising the antenna(s). If there is a line-of-sight connection between the unknown emitter and the directional antenna 400 - such that the direction from the directional antenna 400 to the unknown emitter is detectable - and an advance knowledge that the site of the unknown emitter is on the ground, the emitter may be located using the directional information from the directional antenna 400, the known height of the balloon 10, will say the height of the antenna, and the time difference of arrival of the emitter signal between the directional antenna 400 and the antenna on the captive balloon 10.

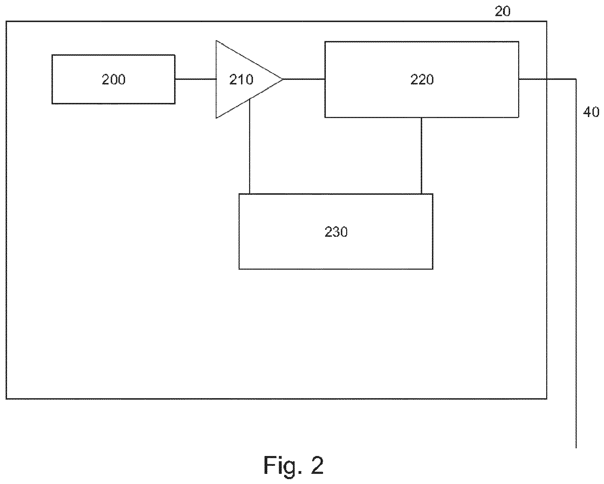

Fig. 2 shows the electronic devices of the airborne part 20 of the RF-locating system in Fig. 1 in more detail. The electronic devices comprise one or more antennas 200, a wide band amplifier 210, an electric-optic-converter circuit 220 and a power supply 230 (a battery or an accumulator) for the wide band amplifier 210 and the electric-optic-converter circuit 220. The antenna 200 receives the RF-signals for the locating system. The wide band amplifier 210 amplifies the received antenna signals to a suitable level. The electric-optic-converter circuit 220 converts the amplified antenna-signals to a form suitable for transmission to the ground by the signal transmission line 40.

Instead of using a battery or an accumulator on the airborne part 20, the devices 210 and 220 could be supplied from the ground by a power supply and electrical leads. However, this implies that two metal wires must be led up and connected to the airborne part 20. Firstly, this increases the payload of the balloon 10. Secondly, in case of a thunderstorm, metal wires are prone to lightning strokes such that suitable countermeasures have to be taken and a lightning protection system must be installed. Therefore, using a power supply on the ground and electrical leads up to the balloon increases not only the payload of the captive balloon 10 but also increases the costs of the overall system, and so it is favourable to use a power supply 230 on the airborne part 20. The power supply may also comprise a electric fuel cell with hydrogen and oxygen as reactants while in most cases a current state of the art lithium polymer battery will provide sufficient power for a session of RF-emitter locating.

A minimal weight of the antenna(s) 200 represents no particular problem. In one embodiment, the antenna 200 may be a thin metal wire of suitable length. This disclosure is concerned with the weight reduction of the remaining payload of the captive balloon without antenna(s) 200 which remaining payload encompasses inter alia the electronic devices 210, 220 and 230, the signal transmission line 40 and the stay rope 30 in additional of the weight of the balloon and any balloon structure. This weight reduction encompasses a reduction of the power consumption of the wide band amplifier 210 and the electric-optic-converter circuit 220 which grossly determine the overall weight of the power supply 230 when the energy comes from a battery, accumulator or fuel cell.

Referring to the weight optimization of the signal transmission line 40 and the stay rope 30, electric cables and fibre optic cables may be used and for transmitting the antenna signals from the balloon to the ground. A conventional electrical cable with a frequency range up to some GHz must be used as a signal transmission line 40 for the usual operating range of RF-locating systems. A cable with such a frequency range must be so-called shielded coaxial cable. When such coaxial cable from the captive balloon to the signal processing equipment 50 on the ground is used, the weight per length of commercially available coaxial cables for this frequency range is about 70 - 100 g/m. When on the other hand a commercially available fibre optic cable can be used as a signal transmission line 40 for the same purpose, the weight per length of the fibre optic cable is about 10 g/m only. In case of a cable length of 100 m, a typical operational height of the captive balloon 10 for establishing a line of sight with the RF-emitter, the difference in weight between the two signal transmission lines is about 6 - 9 kg, and when the weight of the antenna(s), the electronic devices and their housings as carried by the balloon 10 do not exceed 1 kg, which is a realistic overall weight for such a type of equipment, the weight difference of the balloon payload between the two signal transmission modes (electrically, optically) caused by the cables, the antenna(s), the electronic devices and their housing is in the order of about a factor 3 - 5.

This difference gives rise to serious consequences. In Fig. 1, the signal transmission line 40 and the stay rope 30 of the tethered balloon 10 are shown as separate entities. If the forces acting from the balloon 10 on the stay rope 30 (wind forces, buoyancy force) are small (say, when the balloon is small) and below the tensile strength of the signal transmission line itself the stay rope 30 may be omitted and the signal transmission line 40 may take over the role of the stay rope 30. Obviously, the volume of the captive balloon 10 must be much bigger when the signal transmission line 40 is an electric coaxial cable and no fibre optic cable. As disclosed above, the payload of the balloon 10 would have to be increased by a factor of about 3 to 5 in the above example. In turn, the buoyancy and wind forces acting on the stay rope 30 would likewise increase so that the tensile strength of the signal transmission line 40 (coaxial cable) may become too small, requiring a separate stay rope 30 as shown in Fig. 1. Both would again contribute to the payload of the tethered balloon(s) 10, requiring an even further bigger balloon.

Fibre optic cables (in the above example a fibre optic cable with a weight per length of about 10 g/m) typically have a protective covering that is reinforced with synthetic fibres (aramid, Kevlar®) to improve the tensile strength and protect the fibre optic cable against lateral forces. The present inventors investigated the forces applied to such a cable by a balloon having a suitable dimension for carrying the required payload under different operating conditions and found that the forces acting on the cable are below the allowable tensile and lateral forces on the fibre optic cable. Therefore, the inventors contemplated the use of a fibre optic cable as a signal transmission line 40 and stay rope 30. The fibre optic cable is wound on a winder with a suitable diameter to ensure that the allowable bend radius of the fibre optic cable is met. When taking such precautionary measures a separate stay rope 30 is no longer needed and the necessary payload of the captive balloon 10 becomes smaller.

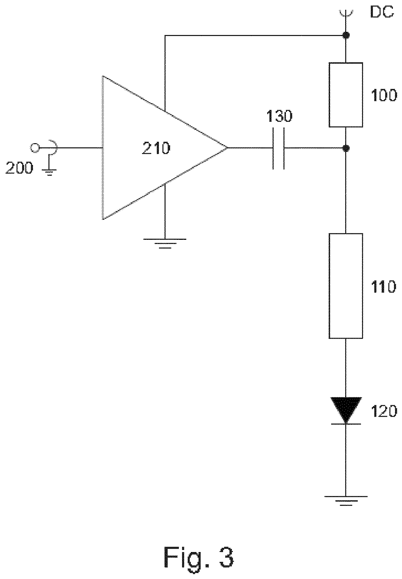

The weight optimization of the airborne electronic devices at the captive balloon 10 will now be described. For a better understanding of the problems in the field of reducing the power consumption of the electric-optic-converter circuits, the basic design of a prior art electric-optic-converter circuit will be explained in short with reference to Fig. 3. Fig. 3 shows a basic circuit diagram of a conventional device for electric-optic-conversion that comprises an antenna 200, an RF wide band amplifier 210, a capacitor 130, a bias resistor 100, a laser diode 120 and a matching resistor 110 connected in series to the laser diode.

The wide band amplifier 210 amplifies the low level antenna signal to a voltage and current level that is suitable to drive the electric-optic-conversion element, will say the laser diode 120. The bias resistor 100 is connected to a DC voltage and biases the laser diode 120 together with the matching resistor 110 to a suitable operating point. The RF-signal from the RF wide band amplifier 210 is coupled to the laser diode 120 by means of the capacitor 130. Because the RF-signal from the wide band amplifier 210 is normally transmitted on a line with a characteristic impedance of 50 Ohm and the internal impedance of suitable laser diodes is about 3 Ohm, a matching resistor 110 of about 47 Ohm has to be used to terminate the transmission line from the wide band amplifier 210 with a matched resistance of 50 Ohm. This means that most of the RF-power generated in the wide band amplifier 210 is converted to heat in the matching resistor 110 and not used for modulating the laser diode 120. The usage of a matching transformer to avoid the matching resistor 110 and the RF-power loss related to it is only possible in a low frequency range.

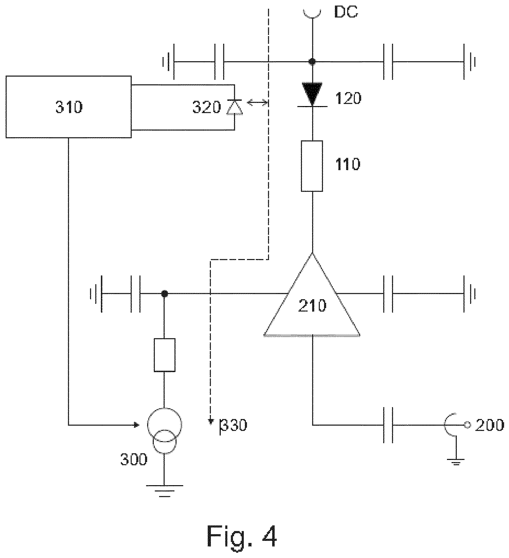

To minimise the power consumption of the electronic devices in the airborne part 20 of RF-locating system, the inventors developed a novel design of the electronic devices according to Fig. 4. In this novel circuit the wide band amplifier 210 for the antenna signal from the antenna 200 and the laser diode 120 are interconnected such that the DC-current 330 that biases the laser diode 120 is passed through the wide band amplifier 210. The DC-current 330 is regulated by a controlled current source 300. A current controller 310 detects the light output by the laser diode 120 by means of a photo diode 320 and drives the controlled current source 300 such that the operating point of the laser diode 120 is adjusted and stabilized. In this way a bias resistor for the laser diode 120 is not necessary and the power loss in the bias resistor is avoided. The dimension of the power supply 230 decreases and a further saving of weight in the payload of the balloon 10 is possible.

The advantages of the present disclosure and embodiments should be obvious but are herein summarized in brief. Using mobile masts that have a height above most buildings and obstacles in a city meanwhile would require often some 100 meters or more. Such masts are not practicable because of the prohibitive costs and the labour and time that is needed to deploy and install such a mast.

A solution to the problem of putting antennas in a sensing position for a line-of-sight connection is using airborne antennas. For example, the antennas could be carried by remotely piloted aircrafts that can take a stationary position in the air such as drones or by captive balloons. Further, there is needed an apparatus which transmits the received RF-signals for the locating system from the air-borne antennas to the processing equipment on the earth.

When drones are used, governmental restrictions and restrictions by the air traffic control must be fulfilled. Moreover, an operator is needed that pilots the air vehicle(s), and the observation time of the drones is limited because of the limitations on fuel or electric power capacities of such air vehicles. Further, drones are more expensive than tethered or captive balloons, and the balloons do not need an operator that permanently controls the altitude and the position of the flying object. Thus, using a captive balloons or aerostat that carries antennas can be solution to the above problems.

When a balloon with antennas is used, it is further desirable to keep the balloon as small as possible to minimize costs and overall weight of the equipment which comprises the balloon itself, the equipment and pressure tanks (helium or hydrogen) to inflate the balloon, transport vehicle, signal processing unit, etc.). The size of the balloon depends largely on the weight that must be carried, which is the payload of the balloon. In turn, this means that the weight of the antennas of the locating system and the weight of the device that transmits the antenna signals to ground and the weight of the device that holds the captive balloon must be likewise kept as small as possible.

The size and weight of the antenna(s) is determined by the design parameters of the locating system and therefore a fixed value for a specific task. Therefore, the inventors recognized that the weight of the apparatus that processes the antenna signals and transmits them from the antenna to the further processing equipment on the ground and the device that holds the captive balloon must be minimized.

While antenna signals can be transmitted in numerous ways, the instant technical problem requires a transmitting of broad band antenna(s) signals from a an aerial platform to a processing equipment on the ground. A wireless solution could be contemplated that amplifies the antenna signals and transmits them as optical signals or radio frequency signals with a directional antenna to the ground. However, since the antenna signals are wide band signals they are prone to distortions by and overlapping with the RF-background in the field, say when just amplified behind the receiving antenna and directed to the ground by a second directional transmission antenna. Further, there can be an interference of the amplified signals from the directional transmission antenna reflected on the ground with the receiving antenna on the balloon. Thus, this is not a feasible solution. Modulating the received antenna signals to another frequency band for downward transmission to avoid this problem is also no preferable solution because of additional complicate equipment and various spectral restrictions in different countries.

For the above reasons, a wired signal transmission from the air-borne antennas to the ground has to be combined with a stay rope best in terms of weight, complexity of the apparatus and safety against interferences. There are two possible approaches for a wired signal transmission from the RF-antenna at the balloon to ground, namely using an RF-cable such as a coaxial cable or a fibre optic cable. The inventors investigated both solutions for the instant disclosure.

Compared to a fibre optic cable, the RF-cable has a higher weight per length and a noticeable attenuation due to the envisaged distance (up to some hundred meters). Further, an electromagnetic interference to the RF-cable cannot be completely ruled out. The attenuation of the fibre optic cable for the envisaged distance can be neglected. An interference from outside to the fibre optic cable is nearly impossible.

To offset the attenuation of the RF-cable, there is needed an adequate antenna signal amplifier behind the antenna on the balloon, and a power source (batteries or accumulators) that can feed the amplifier for the desired observation time of the locating system. Both components (amplifier and power source) contribute to the payload of the balloon so that those must be designed as small as possible. The solution comprises the use of a fibre optic cable. To further minimize the payload a novel electronic circuit design converts the broad-band electrical signals from the antenna to optical signals that can be fed into the fibre optic cable. The described circuit has been designed for a reduced power consumption so that conventional lithium polymer batteries can be used for a typical observation time needed for locating an RF-emitter on the ground.

The present disclosure further relates to a novel method and use of an RF-locating system. Of course, the invention is not limited to the exemplary embodiments explained above. Instead, the scope of the invention is defined by the appended claims.

### List of reference numbers

- 10: tethered balloon
- 20: airborne part of the RF-locating system
- 30: stay rope
- 40: fibre optical link
- 50: processing equipment on the ground
- 100: bias resistor
- 110: matching resistor
- 120: laser diode
- 130: capacitor
- 200: antennas
- 210: wide band amplifier
- 220: electric-optic-converter circuit
- 230: power supply
- 300: controlled current source
- 310: current controller
- 320: photo diode
- 330: DC bias current
- 400: directional antenna
- 410: mast

## Claims

1. Method of locating an RF-emitter on the ground comprising the step of using
a fibre optic cable (40) having a tensile strength sufficiently high to act as a stay rope for an *aerial platform* comprising
a balloon with an air-borne antenna (200) for receiving RF signals from the RF-emitter,
a wide band amplifier (210) that amplifies electrical signals output by the air-borne antenna (200), a power supply (230) supplying power to the wide band amplifier (210), and
an electric-optic-converter (220) that converts amplified electrical signals output by the wide band amplifier (210) to optical signals for transmission on the fibre optic cable (40) to a ground based processing unit (50),
**characterised in that** the ground based processing unit (50) further uses a mast antenna (400) for locating the RF-emitter.

2. Method as claimed in claim 1, wherein in a one-step procedure the RF-signals received by the air-borne antenna (200) and the RF-signals received by the mast antenna (400) are used together with topographical knowledge to calculate the location of the RF-emitter on the ground.

3. Method of claim 1 or 2, wherein the mast antenna (400) is a directional antenna.

4. Method of claim 3, wherein the RF-emitter is located using directional information from the directional mast antenna (400), a height of the balloon (10) and a time difference of arrival of the RF-emitter signal received by the directional mast antenna (400) and the air-borne antenna (200) on the balloon (10).

5. A system operable to locate an RF-emitter on the ground, the system comprising:
a ground-based processing unit (50);
a balloon (10);
an airborne part of an RF-emitter locating system (20) to be carried in use by the balloon, the airborne part comprising
an airborne antenna (200) for receiving RF signals from the RF-emitter,
a wide band amplifier (210) that is operable to amplify electrical signals output by the airborne antenna (200),
a power supply (230) configured to supply power to the wide band amplifier (210), and
an electric-optic-converter (220) that is operable to convert amplified electrical signals output by the wide band amplifier (210) to optical signals and arranged to supply the optical signals to a fibre optical cable (40) for transmission to the ground based processing unit (50); and
a fibre optic cable (40) having a tensile strength sufficiently high to act as a stay rope for the balloon (10) while carrying the airborne part of the RF-emitter locating system (20) and which is operable to provide a signal transmission line between the ground-based processing unit (50) and the airborne part of the RF-emitter locating system (20), **characterised in that** the ground-based processing unit (50) further comprises a mast antenna (400) for locating the RF-emitter.

6. The system as claimed in claim 5, wherein the ground-based processing unit (50) is operable to process the RF-signals received by the air-borne antenna (200) and the RF-signals received by the mast antenna (400) together with topographical knowledge in a one-step procedure to calculate the location of the RF-emitter on the ground.

7. The system as claimed in claim 5, wherein the ground-based processing unit (50) is operable to locate the RF-emitter using directional information from the mast antenna (400), a height of the balloon (10) and a time difference of arrival of the RF-emitter signal received by the mast antenna (400) and the airborne antenna (200) on the balloon (10).

## Patentansprüche

1. Verfahren zur Lokalisierung eines RF-Emitters am Boden, umfassend den Schritt einer Verwendung
eines faseroptischen Kabels (40) mit einer so hohen Zugfestigkeit, dass es als Halteseil für eine fliegende Plattform verwendet werden kann, umfassend
einem Ballon mit einer Bordantenne (200) zum Empfangen von RF-Signalen des RF-Emitters;
einen Breitbandverstärker (210), der die elektrischen Signale verstärkt, die von der Bordantenne (200) ausgegeben werden,
eine Stromversorgung (230), die den Breitbandverstärker mit Strom versieht (210), und
einen elektro-optischen Wandler (220), der die verstärkten elektrischen Signale, welche der Breitbandverstärker (210) ausgibt, umwandelt und die optischen Signale für die Übertragung auf das faseroptische Kabel (40) zu einer bodengebundenen Verarbeitungseinheit (50),
**dadurch gekennzeichnet, dass** die boden-gebundene Prozessoreinheit (50) zudem eine Mastantenne (400) verwendet für eine Lokalisierung des RF-Emitters.

2. Verfahren nach Anspruch 1, wobei in einem Einschritt-Verfahren die RF-Signale, welche von der Bordantenne empfangen werden, und die RF-Signale, die von der Mastantenne empfangen werden, gemeinsam verwendet werden zusammen mit dem topografischen Daten zur Berechnung der Position des RF-Emitters am Boden.

3. Verfahren nach Anspruch 1 oder 2, wobei die Mastantenne (400) eine Richtantenne ist.

4. Verfahren nach Anspruch 3, wobei die Position des RF-Emitters bestimmt wird unter Verwendung der Richtungsinterformation der gerichteten Mastantenne, der Höhe des Ballons (10), und einer Zeitdifferenz zwischen der Ankunft der RF-Emitter-Signale, welche von der gerichteten Mastantenne (400) empfangen werden, und der Bordantenne (200) auf dem Ballon (10).

5. Ein System, betreibbar zur Lokalisierung eines RF-Emitters am Boden, wobei das System umfasst:
eine bodengebundene Prozessoreinheit (50);
einen Ballon (10);
einen fliegenden Teil eines RF-Emitter-Lokalisierungssystem (20), welches von dem Ballon getragen wird,
wobei das fliegende Teil umfasst
eine Bordantenne (200) zum Empfangen von RF-Signalen des RF-Emitters,
einen Breitbandverstärker (210), betreibbar zum Verstärken der elektrischen Signale, welche von der Bordantenne (200) ausgegeben werden
eine Stromversorgung (230), ausgelegt zur Versorgung des Breitbandverstärkers (210) mit Leistung, und
einen elektro-optischen Wandler (220), der betreibbar ist zum Umwandeln der verstärkten elektrischen Signale, welche der Breitbandverstärker (210) ausgibt, in optische Signale und eingerichtet zum Ausgeben der optischen Signale auf ein faser-optisches Kabel (40) zur Übertragung auf eine bodengebundene Prozessoreinheit (50); und
ein faseroptisches Kabel (40) von einer Zugfestigkeit, die so hoch ist, dass sie als Befestigungsseil für einen Ballon (10) dienen kann, welcher den fluggebundenem Teil des RF-Emitter-Lokalisierungssystems trägt (20) und der betreibbar ist zur Bereitstellung einer Signalübertragungsleitung zwischen der bodengebundenen Prozessoreinheit (50) und den fliegenden Teil des RF-Emitter-Lokalisierungssystems (20), **dadurch gekennzeichnet, dass** die bodengebundene Prozessoreinheit (50) zudem umfasst eine Mastantenne (400) zur Lokalisierung der RF-Emitters.

6. System nach Anspruch 5, wobei die bodengebundene Prozessoreinheit (50) betreibbar ist zur Verarbeitung von RF-Signalen, welche die Bordantenne (200) empfangen und der RF-Signale, welche von der Mastantenne (400) empfangen werden zusammen mit den topografischen Daten in einem Einschritt-Verfahren zur Berechnung der Position des RF-Emitters am Boden.

7. System nach Anspruch 5, wobei die bodengebundene Prozessoreinheit (50) betreibbar ist zur Lokalisierung des RF-Emitters unter der Verwendung der Richtungsinformation von der Mastantenne (400), einer Höhe des Ballons (10) und einer Zeitdifferenz der Signalankunft zwischen den RF-Emitter-Signalen, empfangen von der Mastantenne (400) und von der Bordantenne (200) auf den Ballon (10).

## Revendications

1. Procédé de localisation d'un émetteur RF sur le sol comprenant l'étape d'utilisation
d'un câble à fibres optiques (40) ayant une résistance à la traction suffisamment haute pour agir comme un filin hauban pour une *plateforme élévatrice* comprenant
un ballon avec une antenne aéroportée (200) destinée à recevoir des signaux RF de l'émetteur RF,
un amplificateur large bande (210) qui amplifie des signaux électriques fournis en sortie par l'antenne aéroportée (200),
une alimentation électrique (230) alimentant l'amplificateur large bande (210) en électricité, et
un convertisseur électrique-optique (220) qui convertit des signaux électriques amplifiés fournis en sortie par l'amplificateur large bande (210) en signaux optiques pour transmission sur le câble à fibres optiques (40) à une unité de traitement basée au sol (50),
**caractérisé en ce que** l'unité de traitement basée au sol (50) utilise en outre une antenne pylône (400) destinée à localiser l'émetteur RF.

2. Procédé selon la revendication 1, dans lequel dans une procédure à une étape, les signaux RF reçus par l'antenne aéroportée (200) et les signaux RF reçus par l'antenne pylône (400) sont utilisés conjointement avec une connaissance topographique pour calculer la localisation de l'émetteur RF sur le sol.

3. Procédé selon la revendication 1 ou 2, dans lequel l'antenne pylône (400) est une antenne directionnelle.

4. Procédé selon la revendication 3, dans lequel l'émetteur RF est localisé à l'aide d'informations directionnelles provenant de l'antenne pylône directionnelle (400), une hauteur du ballon (10) et une différence de temps d'arrivée du signal d'émetteur RF reçu par l'antenne pylône directionnelle (400) et l'antenne aéroportée (200) sur le ballon (10).

5. Système opérationnel pour localiser un émetteur RF sur le sol, le système comprenant :
une unité de traitement basée au sol (50) ;
un ballon (10) ;
une partie aéroportée d'un système de localisation d'émetteur RF (20) devant être portée en utilisation par le ballon, la partie aéroportée comprenant
une antenne aéroportée (200) destinée à recevoir des signaux RF de l'émetteur RF,
un amplificateur large bande (210) qui est opérationnel pour amplifier des signaux électriques fournis en sortie par l'antenne aéroportée (200),
une alimentation électrique (230) configurée pour alimenter l'amplificateur large bande (210) en électricité, et
un convertisseur électrique-optique (220) qui est opérationnel pour convertir des signaux électriques amplifiés fournis en sortie par l'amplificateur large bande (210) en signaux optiques et agencé pour fournir les signaux optiques à un câble à fibres optiques (40) pour transmission à l'unité de traitement basée au sol (50) ; et
un câble à fibres optiques (40) ayant une résistance à la traction suffisamment haute pour agir comme un filin hauban pour le ballon (10) tout en portant la partie aéroportée du système de localisation d'émetteur RF (20) et qui est opérationnel pour fournir une ligne de transmission de signal entre l'unité de traitement basée au sol (50) et la partie aéroportée du système de localisation d'émetteur RF (20), **caractérisé en ce que** l'unité de traitement basée au sol (50) comprend en outre une antenne pylône (400) destinée à localiser l'émetteur RF.

6. Système selon la revendication 5, dans lequel l'unité de traitement basée au sol (50) est opérationnelle pour traiter les signaux RF reçus par l'antenne aéroportée (200) et les signaux RF reçus par l'antenne pylône (400) conjointement avec une connaissance topographique dans une procédure à une étape pour calculer la localisation de l'émetteur RF sur le sol.

7. Système selon la revendication 5, dans lequel l'unité de traitement basée au sol (50) est opérationnelle pour localiser l'émetteur RF à l'aide d'informations directionnelles issues de l'antenne pylône (400), une hauteur du ballon (10) et une différence de temps d'arrivée du signal d'émetteur RF reçu par l'antenne pylône (400) et l'antenne aéroportée (200) sur le ballon (10).
